# EUROPEAN PATENT SPECIFICATION

(11) **EP 3 029 612 B1**
(45) Date of publication and mention of the grant of the patent: **31.03.2021**
(21) Application number: 15196201.6
(22) Date of filing: 25.11.2015
(51) Int. Cl.: G06K 19/077, H01L 51/50, H05B 33/00, G06Q 10/08

(54) **LOCATING LUGGAGE WITH RFID TAGS**
LOKALISIERUNG VON GEPÄCK MIT RFID-ETIKETTEN
LOCALISATION DE BAGAGE AVEC DES ÉTIQUETTES RFID

(30) Priority: 01.12.2014 US 201414557430
(43) Date of publication of application: 08.06.2016
(73) Proprietor: The Boeing Company, Chicago, IL 60606-1596 (US)
(72) Inventor: PUENTES, Antonio F., Chicago, IL 60606-2016 (US); HENDRIAN, Matthew B., Chicago, IL 60606-2016 (US); BARRACI, Nima, Chicago, IL 60606-2016 (US); AZCUENAGA, Brian A., Chicago, IL 60606-2016 (US)
(74) Representative: Boult Wade Tennant LLP

(56) References cited:
- WO-A1-98/59258
- DE-A1- 19 934 963
- DE-A1-102011 122 797
- DE-A1-102013 207 998
- US-A- 5 693 956
- US-A1- 2002 180 588
- US-A1- 2004 119 593
- US-A1- 2005 005 482
- US-A1- 2007 046 468
- US-A1- 2008 110 977
- US-A1- 2009 167 495
- US-A1- 2010 052 908
- US-A1- 2014 327 520

## Description

### BACKGROUND

A bag-match program such as "Positive Passenger Bag Matching" ensures that no checked baggage is placed aboard an aircraft unless the passenger who checked the baggage is aboard the aircraft. Airlines are required to remove the baggage of any passenger who checks in for a specific flight, but fails to enter the aircraft before departure. Airlines are also required to remove the baggage of any passenger who has already boarded an aircraft but then leaves the aircraft prior to departure.

If the baggage is stored in the aircraft's cargo bay, it must be located and removed from the cargo bay. Typically, ramp personnel climb inside the cargo bay and search every baggage tag for the exact item sought.

However, finding a specific item of baggage in a cargo bay takes time. Cargo bays are cramped and difficult to move around. They are poorly lit or dark. Most times, baggage is not piled in any particular order. Certain items might have to be removed in order to access other items. Additional cargo bays might have to be searched.

While each item is being located, the aircraft sits on a tarmac. If the aircraft sits too long, its time slot might be missed. A missed time slot can also result in costly departure and arrival delays. Substantial delay costs may be incurred for air crews and ground personnel. Substantial delay costs may also be incurred due to passenger misconnections and "knock-on" delays, which are compounded by any delay.

There is a need to quickly identify specific items of baggage in a cargo bay.

DE102013207998 (A1), in accordance with its abstract, states a security or value product with a passive, electroluminescent security element comprising a field-induced electroluminescent device.

US2010052908 (A1), in accordance with its abstract, discloses an RFID tag including a sensor for determining a transient state or condition of a product to which the tag is associated, and a display. The tag may be passive, semi-passive, or active. In response to receipt at the tag of a read signal that includes a first value associated with the transient state or condition, a comparison is performed. The comparison compares the first value, with a second value generated by the sensor in response to receipt of the read signal. As a result of the comparison, an indication is provided on the display. The information displayed is a function of the comparison. In one embodiment, the display provides different color indications depending on the transient state or condition sensed.

US2014327520 (A1), in accordance with its abstract, states a radio identification arrangement comprising a signal emitter and a controller configured to detect whether the radio identification arrangement has received a radio signal which specifies an identification of the radio identification arrangement from a radio identification device or the radio identification arrangement has received a first indication signal from another radio identification arrangement and configured to control the signal emitter to emit a second indication signal if the radio identification arrangement has received a radio signal specifying the identification from a radio identification device or the radio identification arrangement has received a first indication signal from another radio identification arrangement.

### SUMMARY

The invention is defined by the independent claims.

Preferred embodiments are set out in the dependent claims.

These features and functions may be achieved independently in various embodiments or may be combined in other embodiments. Further details of the embodiments can be seen with reference to the following description and drawings.

### BRIEF DESCRIPTION OF THE DRAWINGS

FIG. 1 is an illustration of an apparatus including a passive RFID tag, and an electroluminescent layer on a surface of the RFID tag.
FIG. 2 is an illustration of system for using the apparatus of FIG. 1 to locate an item.
FIG. 3 is an illustration of a display for an RFID reader of the system.
FIG. 4 is an illustration of a method of using the system of FIG. 2 to locate an item of baggage in a cargo bay of an aircraft.

### DETAILED DESCRIPTION

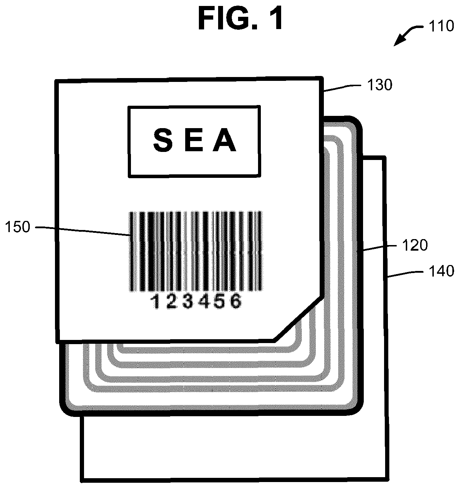

Referring to FIG. 1, a glowable device 110 includes an RFID tag 120, and an electroluminescent layer 130 on a surface of the RFID tag 120. As a first example, the electroluminescent layer 130 may include electroluminescent (EL) ink on a dielectric layer. For instance, the electroluminescent ink and a layer of silver electrode may be silkscreened on the dielectric sheet. As a second example, the electroluminescent layer 130 may include a sheet of electroconductive paper that glows when excited.

The RFID tag 120 may include standard components such as a processor, machine-readable memory, transceiver, and antenna. The RFID device may be interrogated by broadcasting an interrogation signal.

The RFID tag 120 may be active or passive. When a passive RFID tag 120 receives the interrogation signal, it harvests power from the interrogation signal and uses the harvested power for operation. An active RFID tag 120 also receives an interrogation signal, but supplies its own power for operation. For instance, the active RFID tag 120 may carry its own battery.

The operation of the RFID tag 120 includes energizing the electroluminescent layer 130, which causes the electroluminescent layer 130 to glow. Thus, the RFID tag 120 causes the electroluminescent layer 130 to glow in response to an interrogation signal.

The glowable device 110 is configured to be secured to an item. For example, the glowable device 110 may further include an adhesive layer 140 on an opposite surface of the RFID tag 120. The adhesive layer 140 may be used to secure the RFID tag 120 to an item.

The glowable device 110 may further include printed information 150 on the electroluminescent layer 130. The printed information 150 may be provided on a label, which is adhered to a front surface of the electroluminescent layer 130, or the printed information 150 may be printed directly on the electroluminescent layer 130. FIG. 1 provides examples of the printed information 150, which includes a bar code.

The glowable device 110 may be used to identify items in dark places. Even though the amount of energy generated by the RFID tag 120 is relatively low, it is sufficient to cause the electroluminescent layer 130 to create a detectable glow in a dark setting.

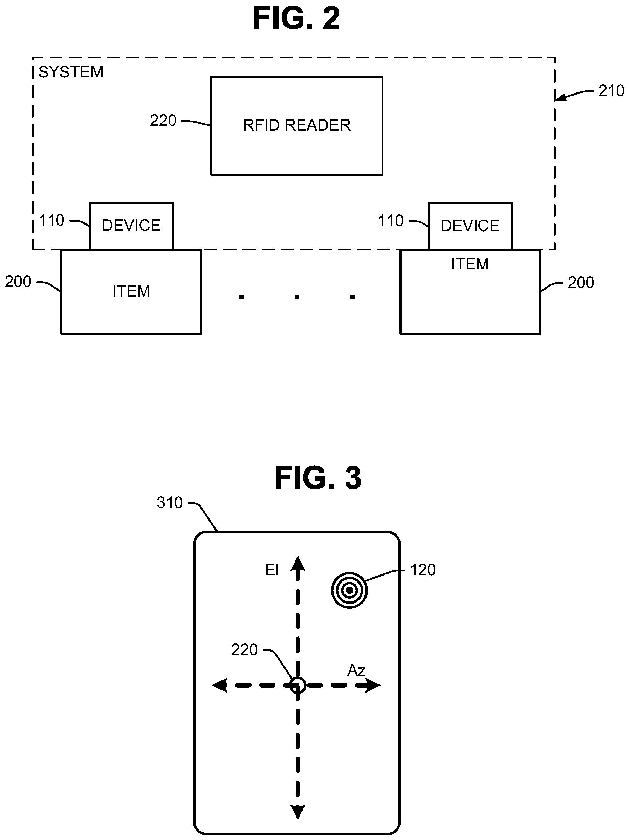

Reference is made to FIG. 2, which illustrates a locating system 210 including a plurality of the devices 110 for locating a plurality of items 200. The RFID tag 120 of each glowable device 110 may be programmed with a unique tag identifier (ID). Each glowable device 110 is configured to be secured to a corresponding one of the items 200.

The locating system 210 further includes an RFID reader 220 for selectively interrogating the RFID tags 120. The RFID reader 220 may be handheld. "Selectively interrogating" refers to interrogating all RFID tags 120 within range of the RFID reader 220, but causing only a selected RFID tag 120 (or selected RFID tags 120) to respond. For instance, the interrogation signal may contain one or more tag identifiers. Each RFID tag 120 within range of the RFID reader 220 receives the interrogation signal. An RFID tag 120 takes an action if its unique tag ID matches a tag identifier in the interrogation signal. The action includes energizing its electroluminescent layer 130 to cause it to glow.

The action may also include transmitting a tag response back to the RFID reader 220. The RFID reader 220 may use that response to determine the position of the RFID tag 120 relative to the RFID reader 220. For instance, the RFID reader 220 may use measurements of receive signal strength indication (RSSI) to determine the relative position of the transmitting RFID tag 120.

The RFID reader 220 may identify relative elevation and azimuth of the transmitting RFID tag 120. The azimuth and elevation may be identified according to polarization of the tag response.

The RFID reader 220 may include a display device and a processor programmed to identify and display a location of the transmitting RFID tag 120 relative to the RFID reader 220. Thus, the display device also shows the location of the item 200 to which the transmitting RFID tag 120 is secured. That is, the display device locates the item 200 being sought.

FIG. 3 illustrates an example of a display 310 on the display device. The display 310 presents lines corresponding to azimuth (Az) and elevation (EI). The RFID reader 220 may be located at the intersection of these lines. The location of the transmitting RFID tag 120 is displayed on the display device. As the RFID reader 220 is moved relative to the transmitting RFID tag 120, the relative location is updated on the display 310.

The locating system 210 is not limited to identifying any particular item 200. Examples of items 200 include, but are not limited to, recalled or expired food in a warehouse, time-limited ammunition in storage, and medicine and safety equipment with expiration dates. However, one particular application for the locating system 210 is identifying specific items of baggage in a cargo bay of an aircraft.

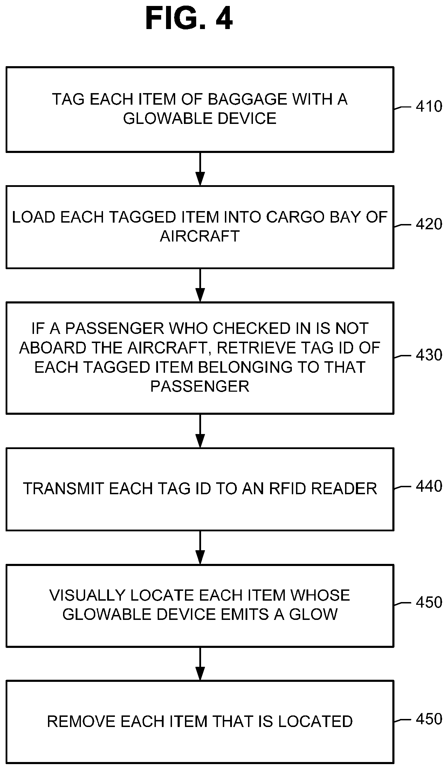

Reference is made to FIG. 4, which illustrates a method of using the locating system 210 to locate specific items 200 of baggage in a cargo bay of an aircraft. At block 410, each item 200 of baggage is tagged with a glowable device 110. For instance, a glowable device 110 is secured to an item 200 during passenger check-in. Prior to securing the glowable device 110, a printer may print out a bar code and other information directly on the electroluminescent layer 130, or the printer may print out the information on a label, which is affixed to the electroluminescent layer 130.

In addition, information including passenger name, tag ID, and aircraft may be entered into a passenger name record (PNR) database. In some instances, the RFID tag 120 may be field programmable, whereby a computer programs a unique tag ID into the RFID tag 120 and enters the unique tag ID in the PNR database. In other instances, the RFID tag 120 is read-only and has a pre-programmed tag ID, whereby the computer reads the tag ID and enters it in the PNR database.

At block 420, each tagged item 200 is routed through the airport to an aircraft. Each tagged item 200 is loaded into the cargo bay of an aircraft.

At some point following check in, a determination is made that the passenger who checked baggage is not aboard the aircraft. This determination may be made during boarding, when each boarding pass is scanned. If a passenger who checked in with baggage has not boarded the aircraft, the flight/gate manager may notify the captain who makes a decision to wait or to unload that passenger's baggage. If a decision is made to unload, the tag IDs of all items belonging to that passenger are retrieved from the PNR database (block 430).

At block 440, each retrieved tag identifier is transmitted to an RFID reader 220. The RFID reader 220 may be operated by cargo handling or other party responsible for removing each one of the passenger's items 200 from the cargo bay of the passenger's aircraft.

At block 450, each tagged item 200 belonging to the passenger is visually located in the cargo bay. Locating a tagged item 200 includes pointing an RFID reader 220 at the cargo bay, using the RFID reader 220 to generate an interrogation signal containing the tag identifier, and looking for a glow in the cargo bay. If the RFID reader 220 can display a location of the transmitting RFID tag 120 relative to the RFID reader 220, the field of search can be narrowed.

At block 460, after a tagged item 200 has been located, it may be removed from the cargo bay.

If the passenger has multiple items 200 of baggage, the RFID reader 220 can interrogate the RFID tags 120 sequentially (and locate/remove one item at a time), or the RFID tags 120 can be interrogated at the same time. For instance, if all of the RFID tags 120 have the same unique identifier, all of the glowable devices 110 will emit a glow during interrogation.

An active RFID tag offers additional advantages over a passive RFID tag. One advantage is being able to pinpoint its exact location (through triangulation) at any point of the airport over several hundred meters.

In some configurations, an RFID tag 120 may also respond to an interrogation signal by generating an audible noise. In an airport, however, the audible noise may not be effective in helping to locate the RFID tag 120, as it would echo in a cargo bay and it might be drowned out by exterior noise.

The locating system 210 is not limited to locating items 200 of a passenger who checked baggage but is not aboard an aircraft. For example, the system 210 may be used to improve the efficiency of off-loading baggage after an aircraft has landed. Tagged items 200 may be located and removed after landing for passengers with very short connections (e.g., short connecting flight periods). Baggage that is lower priority or continuing on to the final destination may be off-loaded last.

The locating system 210 may also be used to find specific items in other parts of an aircraft. The locating system 210 may be used to find items 200 not immediately visible, such as oxygen generators behind panels, specific life vests under seats, and bags in overhead storage.

## Claims

1. A locating system for a plurality of items, the system comprising:
a plurality of glowable devices (110), each glowable device (110) including a passive RFID tag (120) programmed with a unique tag identifier and an electroluminescent layer (130) on a surface of the RFID tag (120), each glowable device being adapted to be secured to one of the items; and
an RFID reader (220) arranged to selectively interrogate the RFID tags (120) based on the unique tag identifier;
wherein an RFID tag (120) is arranged to cause its surface-mounted electroluminescent layer (130) mounted to a first surface of the RFID tag (120) to glow in response to the selective interrogation and to transmit a tag response back to the RFID reader (220) in response to the selective interrogation to enable the RFID reader (220) to determine the position of the RFID tag (120) relative to the RFID reader (220),
**characterized in that** the locating system further uses measurements of received signal strength to determine the relative position of the transmitting RFID tag (120) and identify relative elevation and azimuth of the transmitting RFID tag (120) according to the polarization of the tag response.

2. The system of claim 1 wherein the RFID reader (220) includes a display and a processor programmed to identify and display a location of each RFID tag (120) that transmits a response to the RFID reader (220).

3. The system of any one of claims 1 and 2, wherein each RFID tag (120) is arranged to harvest energy from an interrogation signal to energize its surface-mounted electroluminescent layer (130).

4. The system of any one of claims 1-3, wherein each glowable device (110) further includes an adhesive layer (140) on a second surface of the RFID tag (120) that is opposite the first surface.

5. The system of any one of claims 1-4, wherein each glowable device (110) further includes printed identification information (150) on the electroluminescent layer (130).

6. A method comprising locating an item stored in an aircraft, the item being tagged with a device (110) including an electroluminescent layer (130) that is operated by an RFID tag (120) when the RFID tag (120) is interrogated,
wherein the RFID (120) is programmed with a unique tag identifier, wherein locating the item includes:
using an RFID reader (220) to selectively interrogate the RFID tag (120) based on the unique tag identifier;
receiving a tag response back to the RFID reader (220) in response to the interrogation signal; and
visually locating a glow in response to the selective interrogation,
**characterized in that** the method further comprises:
determining the position of the RFID tag (120) relative to the RFID reader (220) using measurements of received signal strength; and
identifying relative elevation and azimuth of the transmitting RFID tag (120) according to polarization of the tag response.

7. The method of claim 6, further comprising removing from the aircraft the item whose device emits a glow.

8. The method of any one of claims 6 and 7, wherein the item is stored in a cargo bay of the aircraft; and wherein using the RFID reader (220) includes:
receiving a tag identifier of each item belonging to a passenger who checked in but is not aboard the aircraft;
pointing the RFID reader (220) at the cargo bay prior to departure of the aircraft; and
transmitting an interrogation signal towards the cargo bay,
wherein the RFID reader (220) is used to determine and display azimuth and elevation of the RFID tag (120) after the RFID tag (120) transmits a tag response to the RFID reader (220).

9. The method of claim 8, further comprising looking up the tag identifier in a passenger name record PNR database.

10. The method of any one of claims 8 or 9, wherein the item is stored in a cargo bay of the aircraft; and wherein using the RFID reader (220) includes:
receiving a tag identifier corresponding to a passenger;
pointing the RFID reader (220) at the cargo bay after the aircraft has landed; and
transmitting an interrogation signal towards the cargo bay.

## Patentansprüche

1. Ortungssystem für eine Mehrzahl von Gegenständen, wobei das System umfasst:
eine Mehrzahl von leuchtfähigen Vorrichtungen (110), wobei jede leuchtfähige Vorrichtung (110) ein passives RFID-Etikett (120), das mit einer eindeutigen Etikettkennung programmiert ist, und eine Elektrolumineszenzschicht (130) auf einer Oberfläche des RFID-Etiketts (120) umfasst, wobei jede leuchtfähige Vorrichtung eingerichtet ist, um an einem der Gegenstände befestigt zu werden; und
ein RFID-Lesegerät (220), das eingerichtet ist, die RFID-Etiketten (120) basierend auf der eindeutigen Etikettkennung selektiv abzufragen;
wobei ein RFID-Etikett (120) eingerichtet ist, um als Reaktion auf die selektive Abfrage seine an einer ersten Oberfläche des RFID-Etiketts (120) angebrachte oberflächenmontierte Elektrolumineszenzschicht (130) zum Leuchten zu bringen, und als Reaktion auf die selektive Abfrage eine Etikettantwort zurück an den RFID-Leser (220) zu senden, um dem RFID-Leser (220) die Bestimmung der Position des RFID-Etiketts (120) relativ zu dem RFID-Leser (220) zu ermöglichen,
**dadurch gekennzeichnet, dass** das Ortungssystem ferner Messungen der empfangenen Signalstärke verwendet, um die relative Position des sendenden RFID-Etiketts (120) zu bestimmen und die relative Elevation und den Azimut des sendenden RFID-Etiketts (120) anhand der Polarisation der Etikettenantwort zu identifizieren.

2. System nach Anspruch 1, bei dem das RFID-Lesegerät (220) eine Anzeige und einen Prozessor enthält, der programmiert ist, um eine Position jedes RFID-Etiketts (120), das eine Antwort an das RFID-Lesegerät (220) sendet, zu identifizieren und anzuzeigen.

3. System nach einem der Ansprüche 1 und 2, bei dem jedes RFID-Etikett (120) eingerichtet ist, Energie zum Erregen seiner oberflächenmontierten Elektrolumineszenzschicht (130) von einem Abfragesignal zu ernten.

4. System nach einem der Ansprüche 1 bis 3, bei dem jede leuchtfähige Vorrichtung (110) ferner eine Klebstoffschicht (140) auf einer der ersten Oberfläche gegenüberliegenden zweiten Oberfläche des RFID-Etiketts (120) aufweist.

5. System nach einem der Ansprüche 1 bis 4, bei dem jede leuchtfähige Vorrichtung (110) ferner gedruckte Kennungsinformation (150) auf der Elektrolumineszenzschicht (130) aufweist.

6. Verfahren, umfassend das Orten eines in einem Flugzeug gelagerten Gegenstands, wobei der Gegenstand mit einer Vorrichtung (110) etikettiert ist, die eine Elektrolumineszenzschicht (130) enthält, die von einem RFID-Etikett (120) betreibbar ist, wenn das RFID-Etikett (120) abgefragt wird,
wobei das RFID-Etikett (120) mit einer eindeutigen Etikettkennung programmiert ist,
wobei das Orten des Gegenstands umfasst:
Verwenden eines RFID-Lesegeräts (220) zum selektiven Abfragen des RFID-Etiketts (120) auf der Grundlage der eindeutigen Etikettkennung;
Empfangen einer Etikettantwort zurück an das RFID-Lesegerät (220) als Antwort auf das Abfragesignal; und
visuelles Orten eines Leuchtens in Reaktion auf die selektive Abfrage,
**dadurch gekennzeichnet, dass** das Verfahren ferner umfasst:
Bestimmen der Position des RFID-Etiketts (120) relativ zu dem RFID-Lesegerät (220) unter Verwendung von Messungen der empfangenen Signalstärke; und
Identifizieren der relativen Elevation und des Azimuts des sendenden RFID-Etiketts (120) anhand der Polarisation der Etikettantwort.

7. Verfahren nach Anspruch 6, ferner umfassend das Entfernen des Gegenstands, dessen Vorrichtung ein Leuchten aussendet, aus dem Flugzeug.

8. Verfahren nach einem der Ansprüche 6 und 7, wobei der Gegenstand in einem Frachtraum des Flugzeugs gelagert ist; und wobei das Verwenden des RFID-Lesegeräts (220) umfasst:
Empfangen einer Etikettkennung jedes Gegenstands, der zu einem Passagier gehört, der eingecheckt hat, aber nicht an Bord des Flugzeugs ist;
Ausrichten des RFID-Lesegeräts (220) auf den Frachtraum vor dem Abflug des Flugzeugs; und
Senden eines Abfragesignals in Richtung des Frachtraums,
wobei das RFID-Lesegerät (220) verwendet wird, um Azimut und Elevation des RFID-Etiketts (120) zu bestimmen und anzuzeigen, nachdem das RFID-Etikett (120) eine Etikettantwort an das RFID-Lesegerät (220) sendet.

9. Verfahren nach Anspruch 8, ferner umfassend das Nachschlagen der Etikettkennung in einer Passagiernamensdatenbank (PNR).

10. Verfahren nach einem der Ansprüche 8 oder 9, bei dem der Gegenstand in einem Frachtraum des Flugzeugs gelagert ist und das Verwenden des RFID-Lesegeräts (220) umfasst:
Empfangen einer einem Passagier entsprechenden Etikettkennung;
Ausrichten des RFID-Lesegeräts (220) auf den Frachtraum, nachdem das Flugzeug gelandet ist; und
Senden eines Abfragesignals in Richtung des Frachtraums.

## Revendications

1. Système de localisation pour une pluralité d'articles, le système comprenant :
une pluralité de dispositifs pouvant briller (110), chaque dispositif pouvant briller (110) comprenant une étiquette RFID passive (120) programmée avec un identifiant d'étiquette unique et une couche électroluminescente (130) sur une surface de l'étiquette RFID (120), chaque dispositif luminescent étant adapté pour être fixé à l'un des articles ; et
un lecteur RFID (220) agencé pour interroger sélectivement les étiquettes RFID (120) sur la base de l'identifiant d'étiquette unique ;
dans lequel une étiquette RFID (120) est agencée pour amener sa couche électroluminescente montée en surface (130) sur une première surface de l'étiquette RFID (120) à briller en réponse à l'interrogation sélective et pour transmettre une réponse d'étiquette en retour au lecteur RFID (220) en réponse à l'interrogation sélective afin de permettre au lecteur RFID (220) de déterminer la position de l'étiquette RFID (120) par rapport au lecteur RFID (220),
**caractérisé en ce que** le système de localisation utilise en outre des mesures d'intensité de signal reçu pour déterminer la position relative de l'étiquette RFID transmettrice (120) et identifier l'élévation et l'azimut relatifs de l'étiquette RFID transmettrice (120) en fonction de la polarisation de la réponse d'étiquette.

2. Système selon la revendication 1, dans lequel le lecteur RFID (220) comprend un affichage et un processeur programmés pour identifier et afficher un emplacement de chaque étiquette RFID (120) qui transmet une réponse au lecteur RFID (220).

3. Système selon l'une quelconque des revendications 1 et 2, dans lequel chaque étiquette RFID (120) est agencée pour récolter de l'énergie à partir d'un signal d'interrogation afin d'activer sa couche électroluminescente montée en surface (130).

4. Système selon l'une quelconque des revendications 1 à 3, dans lequel chaque dispositif pouvant briller (110) comprend en outre une couche adhésive (140) sur une seconde surface de l'étiquette RFID (120) qui est opposée à la première surface.

5. Système selon l'une quelconque des revendications 1 à 4, dans lequel chaque dispositif pouvant briller (110) comprend en outre des informations d'identification imprimées (150) sur la couche électroluminescente (130).

6. Procédé comprenant une localisation d'un article stocké dans un aéronef, l'article étant étiqueté avec un dispositif (110) comprenant une couche électroluminescente (130) qui est actionnée par une étiquette RFID (120) lorsque l'étiquette RFID (120) est interrogée,
dans lequel l'étiquette RFID (120) est programmée avec un identifiant d'étiquette unique, dans lequel la localisation de l'article comprend les étapes consistant à :
utiliser un lecteur RFID (220) pour interroger sélectivement l'étiquette RFID (120) sur la base de l'identifiant d'étiquette unique ;
recevoir une réponse d'étiquette en retour vers le lecteur RFID (220) en réponse au signal d'interrogation ; et
localiser visuellement une brillance en réponse à l'interrogation sélective,
**caractérisé en ce que** le procédé comprend en outre les étapes consistant à :
déterminer la position de l'étiquette RFID (120) par rapport au lecteur RFID (220) en utilisant des mesures d'intensité de signal reçu ; et
identifier l'élévation et l'azimut relatifs de l'étiquette RFID transmettrice (120) en fonction de la polarisation de la réponse d'étiquette.

7. Procédé selon la revendication 6, comprenant en outre le retrait à partir de l'aéronef de l'article dont le dispositif émet une brillance.

8. Procédé selon l'une quelconque des revendications 6 et 7, dans lequel l'article est stocké dans une soute de l'aéronef ; et dans lequel l'utilisation du lecteur RFID (220) comprend les étapes consistant à :
recevoir un identifiant d'étiquette de chaque article appartenant à un passager qui s'est enregistré mais n'est pas à bord de l'aéronef ;
pointer le lecteur RFID (220) vers la soute avant le départ de l'aéronef ; et
transmettre un signal d'interrogation vers la soute,
dans lequel le lecteur RFID (220) est utilisé pour déterminer et afficher l'azimut et l'élévation de l'étiquette RFID (120) après que l'étiquette RFID (120) a transmis une réponse d'étiquette au lecteur RFID (220).

9. Procédé selon la revendication 8, comprenant en outre une recherche de l'identifiant d'étiquette dans une base de données d'enregistrement de nom de passager, PNR.

10. Procédé selon l'une quelconque des revendications 8 ou 9, dans lequel l'article est stocké dans une soute de l'aéronef ; et dans lequel l'utilisation du lecteur RFID (220) comprend les étapes consistant à :
recevoir un identifiant d'étiquette correspondant à un passager ;
pointer le lecteur RFID (220) vers la soute après que l'aéronef a atterri ; et
transmettre un signal d'interrogation vers la soute.
